# EUROPEAN PATENT APPLICATION

(11) **EP 4 044 378 A1**
(43) Date of publication of application: **17.08.2022**
(21) Application number: 22156740.7
(22) Date of filing: 15.02.2022
(51) Int. Cl.: H01R 13/453

(54) **ELECTRICAL CONNECTOR WITH A COVER STRUCTURE AS WELL AS A MATING CONNECTOR AND A CONNECTOR ASSEMBLY**

(30) Priority: 15.02.2021 IN 202141006230
(71) Applicant: TE Connectivity India Private Limited, 560048 Karnataka (IN)
(72) Inventor: KT, Gopi, 560048 Bangalore (IN); KARTHIK, Hariharan Iyer, 560048 Bangalore (IN)
(74) Representative: Grünecker Patent- und Rechtsanwälte PartG mbB

(57) **Abstract**

The present invention relates to an electrical connector (1) comprising at least one contact element (16) and a cover structure (20) for restricting access to the at least one contact element (16), wherein the cover structure (20) comprises a wall element (22) at least partially surrounding the at least one contact element (16) in a spaced apart manner, thereby defining a reception zone (28) between the wall element (22) and the at least one contact element (16), and a cover element (30), which is movable within the reception zone (28) along a retraction direction (36) from a secured position (32) to a retracted position (34), wherein the at least one contact element (16) is enclosed by the cover element (30) in the secured position (32), and wherein the wall element (22) comprises at least one deflectable latch member (38) for securing the cover element (30) in the secured position (32). Due to the movability of the cover element (30), the cover structure (20) may form a gapless finger protection for the at least one contact element (16), which yet allows access to the mating contact (64) of a mating connector (2). The cover element (30) is further configurable for automatic retraction, thereby eliminating the necessity for additional steps during the mating process. The invention further relates to a mating connector as well as a connector assembly.

## Description

### Technical Field to which the Invention Relates

The present invention relates to an electrical connector and, more particularly, to an electrical connector with a cover structure e.g., for high-voltage and high-amperage applications. Further, the present invention relates to a mating connector for an electrical connector as well as a connector assembly with an electrical connector and mating connector.

### Background Art

Electrical connectors are provided for establishing electrical connections, which serve the purpose of transferring electrical energy and/or signals. In the case of energy transfer in particular, a safety risk arises, which needs to be addressed accordingly. For example, before establishing said electrical connections, unintended contact of human fingers and tools with current carrying components of the electrical connectors (e.g. contact elements) needs to be prevented. Simultaneously, the contact elements need to maintain a certain accessibility, since the functionality of electrical connectors mostly relies on mating contacts of mating connectors engaging in electrical contact with the contact elements.

Existing solutions employ finger protection for the contact elements. Said finger protection, however, often leaves small gaps for the mating contacts, through which particularly small fingers and thin tools can unintendedly reach the contact elements. Gapless finger protection on the other hand often requires additional steps of attachment and/or removal. This renders the mating process cumbersome. Lastly, finger protection, which does not require such additional steps during the mating process often employs delicate cover elements, which exhibit low insulation capability, and is thus not suited for applications with high voltages and high currents.

### Technical Object to be achieved

The object of the present invention is therefore to provide means for electrical connections with finger protection, which leaves no unnecessary gaps, exhibits high insulation capabilities and requires no additional steps during the mating process.

### Disclosure of Invention

This object is achieved by providing an electrical connector comprising at least one contact element and a cover structure for restricting access to the at least one contact element, wherein the cover structure comprises a wall element at least partially surrounding the at least one contact element in a spaced apart manner, thereby defining a reception zone between the wall element and the at least one contact element. The cover structure further comprises a cover element, which is movable within the reception zone along a retraction direction from a secured position to a retracted position, wherein the at least one contact element is enclosed by the cover element in the secured position, and wherein the wall element comprises at least one deflectable latch member for securing the cover element in the secured position.

In the context of the present disclosure, it is to be understood that the term "deflectable" refers to property of the at least one latch member according to which the at least one latch member is more elastic, more flexible, more resilient and/or more pliable than the rest of the wall element. In other words, a deflection of the at least one latch member requires less force than a comparable deflection of any other part of the wall element. Optionally, the at least one latch member may also exhibit higher elasticity, flexibility, resiliency and/or pliability than the cover element.

According to this solution, the cover structure may form gapless finger protection for the at least one contact element, especially when the cover element is in the secured position. Yet, the possibility to access the at least one contact element is not entirely eliminated, since the cover element is only selectively secured in the secured position by a deflectable means i.e., the at least one deflectable latch member, and otherwise movable out of the secured position. Advantageously, this results in a selective restriction of access to the at least one contact element, which prevents fingers and tools from reaching the at least one contact element, while allowing a mating contact of a mating connector access to the at least one contact element, if necessary.

Further, by providing the cover element with a movability, the cover element can be configured to automatically move e.g., slide, from the secured position to the retracted position. Thus, the cover element is automatically retractable and the necessity of additional steps during the mating process is removed. Moreover, the cover element can be configured to automatically move from the retracted position back to the secured position, thereby removing additional steps during the un-mating process.

Lastly, by providing the at least one deflectable latch member on the wall element i.e., on a static part of the cover structure, the movable cover element is not unnecessarily required to possess a particularly high elasticity. Thereby, material from a wider range is selectable for the cover element. In particular, the material selection can be focused on the insulation capability of the material. Thus, the cover element immediately enclosing the at least one contact element may be provided with a higher insulation capability than the wall element, which is spaced apart from the at least one contact element. This renders the inventive electrical connector applicable for high-voltage and high-amperage applications.

The above solution may be further improved by adding one or more of the following optional features. Hereby, each of the following optional features is advantageous on its own, and may be combined independently with any other optional feature.

In one possible embodiment of the electrical connector, the at least one contact element may comprise at least one contact surface, which extends along the retraction direction and borders the reception zone. In particular, the at least one contact surface may face the reception zone and the wall element, while being spaced apart from the wall element by the reception zone. In particular, the wall element may surround the at least one contact surface only from directions perpendicular to the retraction direction. Thus, the at least one contact surface is accessible to the mating contact, which is inserted into the reception zone along the retraction direction. Preferably, the at least one contact surface is covered in the retraction direction by the cover element and thus protected to prevent anything other than the mating contact from access to the at least one contact surface.

Optionally, the at least one contact element is a tab-shaped contact made of copper and/or other electrically conductive material. Alternatively, the at least one contact element may be pinshaped, sleeve-shaped, fork-shaped or have any other shape common for electrical contact elements. Further, the at least one contact element may have two contact surfaces on opposite sides thereof. The two contact surfaces may face outwardly and away from each other. Alternatively, the two contact surfaces may face inwardly towards each other.

According to another embodiment, the cover structure may further comprise a cap element, which covers at least a tip section of the at least one contact element. The cap element may be mechanically attached, glued, overmolded or otherwise fixed to the tip section of the at least one contact element. Preferably, the cap element covers the tip section of the at least one contact element in the retraction direction. In other words, the cap element protects the tip section against access from the retraction direction.

Optionally, the cap element may further extend along at least one side edge of the at least one contact element. Preferably, the cap element may extend along two opposite side edges of the at least one contact element, thereby at least partially encircling the at least one contact element. Thus, the cap element may cover the side edges of the at least one contact element perpendicular to the retraction direction.

According to another possible embodiment, the wall element in combination with the cap element forms a finger protection for the at least one contact element according to DIN-EN-Standard 60592. In other words, a finger probe having a dimension as defined in DIN-EN-Standard 60592 is hindered by the wall element and/or the cap element from reaching the at least one contact element.

According to yet another possible embodiment, the wall element, the cap element and the cover element in the secured position jointly form a finger protection for the at least one contact element according to DIN-EN-Standard 60592 and UL-Standard 60950. In other words, neither the finger probe having the dimensions as defined in DIN-EN-Standard 60592 nor a finger probe having a dimension as defined in UL-Standard 60950 can reach the contact element, due to being hindered therefrom by the wall element, the cap element and/or the cover element in the secured position.

In order to guide and thereby stabilize the movement of the cover element, the cover element may comprise an orifice for passing the at least one contact element and/or the cap element therethrough. The orifice may in particular be a slit extending in the retraction direction through the cover element. The orifice is preferably thin enough to prevent entry of any of the finger probes mentioned above. Further, the orifice may be shaped complementarily to a cross-section of the cap element perpendicular to the retraction direction, thereby allowing passage of the cap element encircling the at least one contact element, while keeping gaps therebetween to a minimum. Alternatively or additionally, the orifice may be shaped with a certain space between the at least one contact element to ensure that no contact with the at least one contact surface or the two contact surfaces of the at least one contact element takes place.

Another guiding function may be achieved by forming on the at least one latch member at least one guiding groove extending in the retraction direction. The at least one guiding groove may be configured for receiving parts of the cover element and/or parts of the mating connector, as will be described in further detail below.

For increased safety and redundancy, the wall element may comprise at least two latch members, which are arranged opposite to each other with respect to the at least one contact element. Each latch member may secure the cover element in the secured position against movement. In particular, each latch member may comprise at least one blocking surface, which faces against the retraction direction and serves as an abutting surface for the cover element.

Further, each latch member may comprise at least one bevel surface, which extends obliquely with respect to the retraction direction. Each bevel surface fulfills the purpose of a lead-in chamfer for the mating connector. As will be described further below, the mating connector may comprise at least one deflection element with an inverse surface, which is positioned and oriented in such a way to engage with the at least one bevel surface, when the electrical connector and the mating connector are mated. In particular, said engagement causes the at least one latch member to be deflected.

In order to clearly and visibly indicate the location for insertion of the mating contact of the mating connector, outer edges of the wall element may define an access opening leading into the reception zone. Preferably, the access opening may be open in the retraction direction for the mating contact to be inserted into the reception zone through the access opening.

For clear and visible indication of the location for insertion of the mating connector itself, the electrical connector may further comprise a connector housing forming a connector face. The connector face may be a male connector face configured to be inserted into a complementarily formed female connector face of the mating connector. Alternatively, the connector face of the electrical connector may be a female connector face adapted to receive a male connector face of the mating connector. The male connector face and the female connector face may be mated along a mating direction. The mating direction is preferably parallel to the retraction direction.

For the purpose of electrical energy transfer, the at least one contact element may be soldered, crimped, welded and/or connected by any other conventional termination technique to a conductor of an electrical cable within the connector housing. Further, the withdrawal zone described above may lie within the connector housing.

The cover structure may be embodied by the connector housing or be separately assembled to the connector housing. Alternatively, parts, such as the wall element, of the cover structure may be monolithically connected to the connector housing. Other parts, such as the cover element, of the cover structure may be assembled to the connector housing as separate components.

Optionally, the cover element is movable from the retracted position to the secure position. Preferably, the cover element is reciprocally movable between the secured position and the retracted position, wherein the access opening is closed by the cover element in the secured position, and wherein the reception zone is accessible through the access opening, when the cover element is in the retracted position. Thereby, the access opening may be repeatedly opened and closed, restricting the access to the at least one contact element when needed.

In the secured position, the cover element may at least partially, preferably chiefly, occupy the reception zone. In particular, the cover element may comprise at least one plate section, which blocks the access opening when the cover element is in the secured position. Preferably, when the cover element is in the secured position, the contact element is positioned beyond the plate section in the retraction direction. Thereby, a certain travel distance of the cover element is necessary, until the respective contact element is made accessible. This results in a certain level of protection, even if the cover element is forcefully pushed.

In the retracted position, the reception zone may be vacated by the cover element. In other words, when the cover element is moved into the retracted position, at least part of the contact element, such as the contact surface, is neither enclosed nor covered by the cover element. In particular, the cover element may be moved into a withdrawal zone, which is aligned with the reception zone in the retraction direction. Preferably, the withdrawal zone lies opposite of the access opening with respect to the reception zone. The withdrawal zone may have a smaller clear width than the reception zone, the clear widths being measured particularly to the retraction direction.

According to another possible embodiment, the cover element may comprise at least one blocking feature for engaging with the at least one latch member. For example, the at least one blocking feature may be a nib-shaped blocking protrusion, which extends away from the plate section of the cover element perpendicularly to the retraction direction. The blocking protrusion may be aligned with the at least one blocking surface of the at least one latch member in its undeflected state. Thereby, the blocking protrusion may abut in the retraction direction against the at least one latch member. This leads to the cover element being maintained in its secured position by a feature that is easy to manufacture.

If the at least one latch member is or both latch members are deflected e.g., away from the cover element, the at least one blocking surface and the blocking protrusion or both blocking surfaces and corresponding blocking protrusions are brought out of alignment and thus do not abut against each other. This way, the cover element is released and can be moved into the retracted position.

According to an alternative embodiment, the at least one blocking feature may be a notch extending through the plate section perpendicularly to the retraction direction. Consequently, the at least one blocking surface may be formed e.g., on a stopping protrusion extending away from the at least one latch member and into the notch. The remaining functionality may be analogous as described above.

Preferably, the cover element comprises, for each latch member of the wall element, at least one blocking feature. Each latch member may comprise at least two blocking surfaces. Accordingly, the cover element may comprise, for each blocking surface, at least one blocking feature. This results in increased stability during the abutment between the blocking features and blocking surfaces.

According to another possible embodiment, the cover element may comprise at least one catch section for interacting with a snap element of the mating connector. As will be described further below, the mating connector may comprise at least one snap element for forming a connection, such as a snap-fit connection, with the at least one catch section.

For the sake of cost-reduction, the cover element may be a single-piece component, preferably molded from resin. Alternatively, the cover element may be manufactured by additive manufacturing and/or made from other electrically insulative materials.

It is to be understood that another aspect of the present invention relates to a cover element for a cover structure of an electrical connector. The cover element may have any combination of the above-described features. The cover element is advantageous, since it may be readily assembled to a cover structure of an electrical connector, where it fulfills the function described above, thereby at least partially achieving the initial object.

Yet another aspect of the present invention relates to a cover structure of an electrical connector. The cover structure may have any combination of the above-described features. The cover structure is thus advantageous, since it may fulfill the functions described above, thereby at least partially achieving the initial object.

The initial object is also at least partially achieved by a mating connector for establishing an electrical connection with the electrical connector according to any of the above embodiments. The mating connector comprises at least one mating contact for electrically contacting the at least one contact element of the electrical connector, and at least one deflection element for deflecting the at least one latch member of the electrical connector.

This mating connector is advantageous, since it can cooperate with the electrical connector in a way that allows the cover element of the electrical connector to be released from the secured position automatically without requiring any additional steps during the mating process. Further, the mating connector can be used to selectively lift the restriction of access to the at least one contact element by the cover structure of the electrical connector. Thus, the cover structure of the electrical connector can form gapless finger protection for the at least one contact element of the electrical connector, without limiting the functionality of the electrical connector.

The mating connector may comprise a mating housing with a female connector face configured for receiving the male connector face of the electrical connector, as already described above. The mating housing may comprise a counterpart cover structure, which is formed complementarily to the cover structure of the electrical connector. Preferably, the counterpart cover structure fits precisely into the cover structure of the electrical connector, in order to prevent any creation of unnecessary gaps. In particular, the mating housing may comprise a mating cover arranged within the female connector face. The mating cover may comprise, for each mating contact, a pillar-shaped contact guard extending along the mating direction. Each contact guard may surround the corresponding mating contact. Further, each contact guard may be formed complementarily to the reception zones of the electrical connector. Each contact guard may further have a slot which is shaped complementarily to the cap element of the electrical connector. Optionally, the shape of the slot may be congruent with the shape of the orifices of the cover element of the electrical connector.

According to one possible embodiment of the mating connector, the at least one deflection element may be a hump-shaped or prismatic bulge formed on the mating housing of the mating connector, in particular on a top surface of the contact guard. Said bulge may exhibit the inverse surface, which was described above. Before and/or while inserting the contact guard into the reception zone, the inverse surface and the bevel surface of each latch member slide along each other. Since these surfaces extend obliquely with respect to the mating direction, the movement of the mating connector in the mating direction is transformed into a movement of the latch member perpendicularly to the mating direction. In other words, the latch member is wedged aside by the deflection element, thus deflecting the latch member away from the cover element. As already described above, such a deflection leads to the respective blocking surfaces and blocking features being brought out of alignment and out of abutment. Hence, the cover element is released. Preferably, the cover element can only be released by means of the mating connector.

Optionally, the at least one latch member is also deflected, when the at least one deflection element leaves the reception zone.

The at least one guiding groove introduced above may be configured for receiving the at least one deflection element of the mating connector and/or the blocking features of the cover element. Besides guiding and stabilizing the movement of the mating connector and/or the cover element, this feature further fulfills the following function:
In order to prevent breaking off the at least one latch member, the at least one latch member is only deflected, when the at least one deflection element enters the corresponding reception zone of the electrical connector. In other words, the at least one latch member is only deflected, when the at least one deflection element is in the access opening. As the at least one deflection element is moved away from the access opening and towards the withdrawal zone, the at least one deflection element is received within one of the guiding grooves formed on the corresponding latch member. In particular, the at least one deflection element is entirely accommodated within the guiding groove and thus does not mechanically interfere with the corresponding latch member.

Analogously, each blocking feature is also received and entirely accommodated within one of the guiding grooves, so as to not mechanically interfere with the corresponding latch member, except when the cover element is in the secured position.

According to another possible embodiment, the mating connector may further comprise at least one snap element pointing in the retraction direction for forming a connection, such as a snap-fit connection, with the electrical connector, in particular with the at least one catch section of the electrical connector. Said snap-fit connection allows the cover element to closely follow a movement of the mating connector along the retraction direction. In particular, the cover element does not move into the retracted position by its own gravity. In other words, the cover element does not fall into the withdrawal zone as long as the snap-fit connection with the mating connector is in place. The cover element only moves into the retracted position, when pushed by the mating connector.

Accordingly, the cover element is pulled out of the withdrawal zone and returned to the secured position by the mating connector via the snap-fit connection, when the mating connector is moved against the retraction direction e.g., during the un-mating process. Thereby, an occurrence of a gap between the mating connector and the cover element after the release of the cover element from the secured position is prevented at all times.

Additionally or alternatively, a resilient position restoration element, such as a coil spring can be used to bias the cover element towards the secured position and out of the retracted position.

According to yet another possible embodiment, the at least one snap element may be a hook-shaped, knob-shaped or rib-shaped projection formed on the mating connector and pointing against the mating direction. In particular, the at least one snap element may be formed on the top surface of the contact guard. This represents an easy to manufacture embodiment of the at least one snap element.

The at least one catch section may be formed by a side wall of the cover element and a flexible cantilever beam extending parallel to the side wall along the retraction direction. The side wall and/or the cantilever beam may have a catching protrusion extending towards the cantilever beam or the side wall, respectively. Alternatively, the at least one catch section may be formed by two flexible cantilever beams extending parallel to each other.

Thus, the at least one snap element may be received within the at least one catch section. Upon reception of the at least one snap element in the at least one catch section, the snap-fit connection may be established.

To ensure that the snap element is not let go by the catch section, unless the cover element is in the secured position, the catch section may exhibit a higher rigidity when the cover element is in the retracted position than when the cover element is in the secured position. This can be achieved as follows:
In the retracted position of the cover element, the cantilever beam is positioned within the withdrawal zone. In particular, the clear width of the withdrawal zone described above is such that the cantilever beam rests against the wall element. Thus, the cantilever beam is limited in its movement or entirely loses its flexibility. Thereby, the at least one snap element is firmly held within the at least one catch section.

In this case, the terms "firmly held" refer to a state where a force required for pulling the snap element out of the catch section is larger than the weight force of the cover element and/or the friction force acting between the cover element and the rest of the electrical connector.

In the secured position of the cover element, the cantilever beam is positioned within the reception zone. Due to the larger clear width of the reception zone compared to the withdrawal zone as described above, the cantilever beam is spaced apart from the wall element and thus maintains its flexibility. Consequently, the at least one snap element can easily enter or leave the at least one catch section.

It is to be understood that the terms "easily enter or leave" refer to a state where the force required for inserting the snap element into the catch section as well as pulling the snap element out of the catch section is smaller than a resisting force acting between the cover element and the rest of the electrical connector. Said resisting force may, for example, derive from hook-shaped anchoring latches, which are formed on the cover element and engage in a latching connection with the wall element.

For the purpose of redundancy and/or stability, the mating connector may comprise multiple snap elements. Accordingly, each cover element may comprise one catch section for each snap element. Alternatively, the allocations of the snap elements and the catch sections may be inverted between the electrical connector and the mating connector.

According to another possible embodiment, the electrical connector may comprise multiple contact elements. In this case, the cover structure preferably comprises, for each contact element, a wall element, a cover element and/or a cap element. For increased stability, the wall elements may be monolithically connected to each other. Alternatively, the cover structure may comprise one wall element for all contact elements. Also alternatively, the cover structure may comprise one cover element for all contact elements.

The initial object is also achieved by a connector assembly comprising an electrical connector and a mating connector according to any one of the above described embodiments, respectively, wherein the at least one latch member of the electrical connector is deflected by the at least one deflection element of the mating connector, when the at least one deflection element enters the reception zone of the electrical connector.

The inventive connector assembly is advantageous, since it adopts the above-explained features and advantages of the inventive electrical connector and mating connector. In particular, the cover element is automatically released from the secured position and pushed into the retracted position by the mating connector. Thus no additional steps are required during the mating process.

Optionally, one of the electrical connector and mating connector may comprise a lever for facilitating the mating process. Further, one of the electrical connector and mating connector may optionally comprise a sealing element, which is interposed between the electrical connector and the mating connector in a mated condition.

Any references to standards made in the present disclosure (e.g. DIN-EN standard, UL standard, etc..) are to be understood as referring to the current standards at the time of filing.

In the drawings:
- Fig. 1: shows a schematic representation of a partially exploded, perspective view of an electrical connector according to one possible embodiment of the present disclosure;
- Fig. 2: shows a schematic representation of a perspective view of the electrical connector according to the embodiment shown in Fig. 1;
- Fig. 3: shows a schematic representation of another perspective view of the electrical connector according to the embodiment shown in Fig. 1;
- Fig. 4: shows a schematic representation of a sectional view of a mating connector according to one possible embodiment of the present disclosure;
- Fig. 5: shows a schematic representation of a detail of a sectional view of a connector assembly according to one possible embodiment of the present disclosure; and
- Fig. 6: shows a schematic representation of a detail of a sectional side view of the connector assembly according to the embodiment shown in Fig. 5.

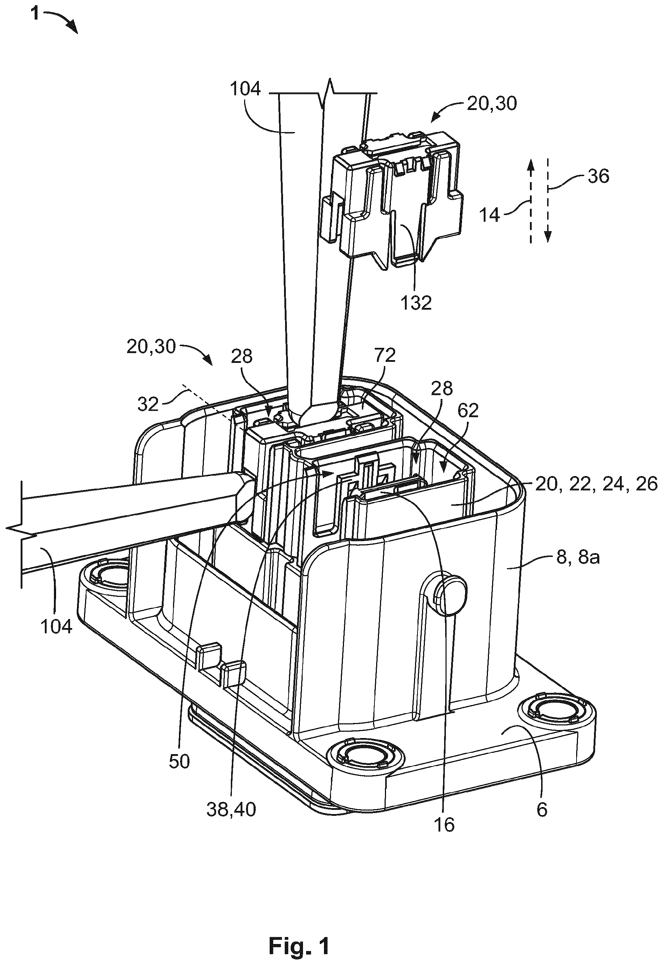

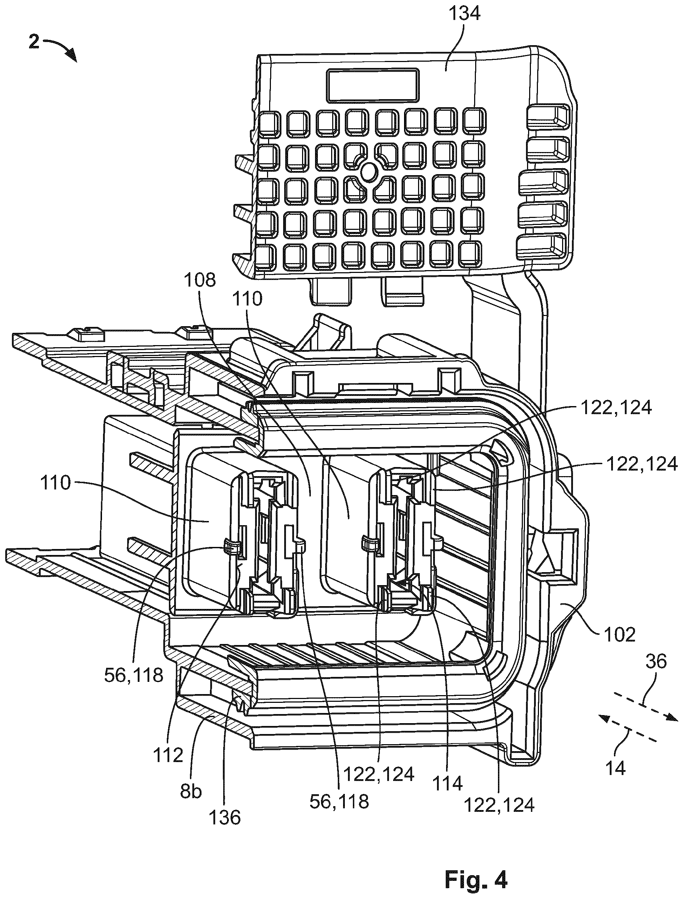

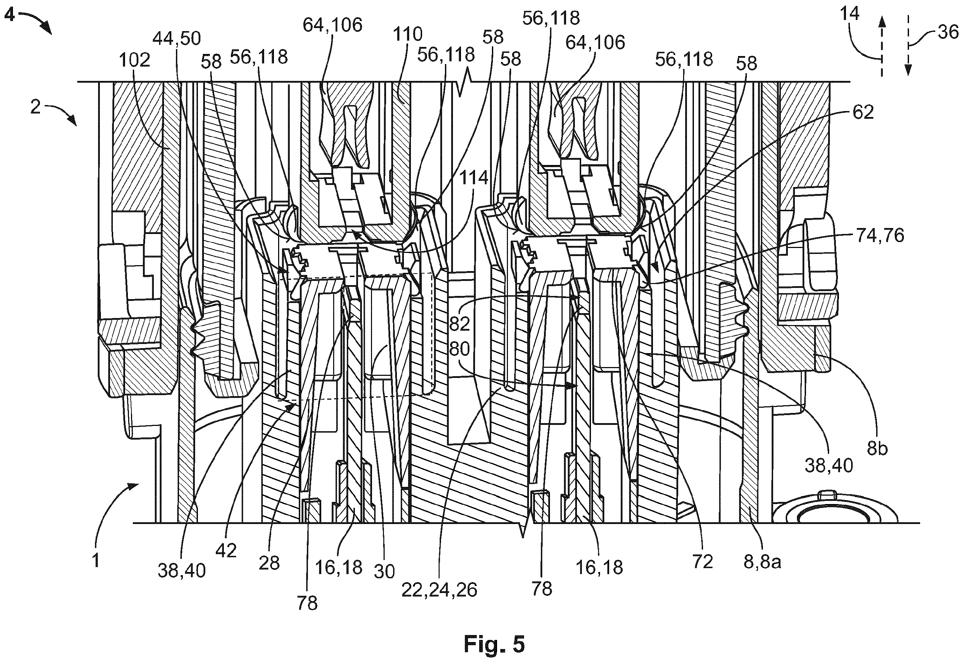

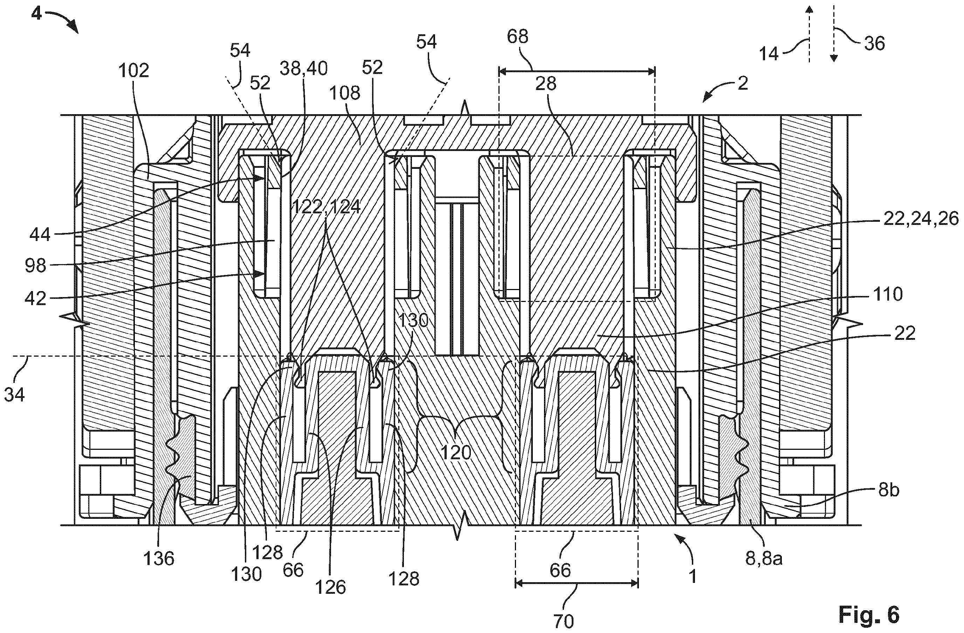

In the following, the structure of an exemplary embodiment of an electrical connector 1 according to the present invention is explained with reference to Figs. 1 to 3. Fig. 4 is used for explaining the structure of an exemplary embodiment of a mating connector 2 according to the present invention. Further, Figs. 5 and 6 are used for explaining the structure and function of a connector assembly 4 according to an exemplary embodiment of the present invention.

Figs. 1 to 3 show perspective views of the electrical connector 1 according to an exemplary embodiment of the present disclosure. The electrical connector 1 may comprise a connector housing 6 forming a connector face 8. In the shown exemplary embodiment, the connector face 8 is a male connector face 8a configured to be inserted into a complementarily formed female connector face 8b of the mating connector 2 (see Fig. 4). Alternatively, the connector face 8 of the electrical connector 1 may also be a female connector face adapted to receive a male connector face of the mating connector 2. The male connector face 8a and the female connector face 8b may be mated along a mating direction 14.

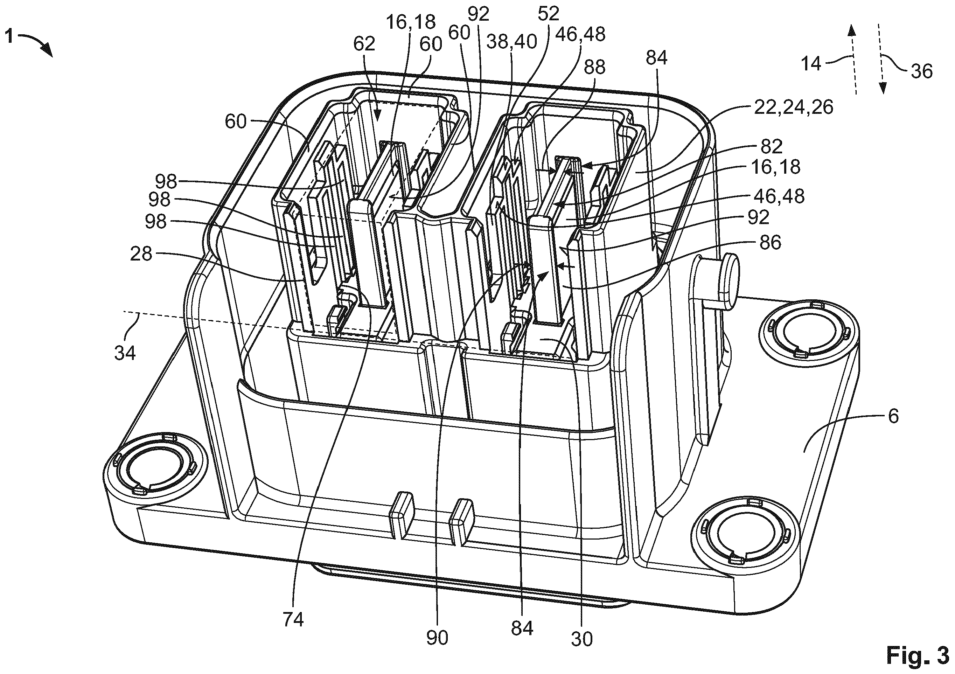

The electrical connector 1 may comprise at least one electrically conductive contact element 16 (see Fig. 3). The at least one contact element 16 may for example be a tab-shaped contact 18 pointing in the mating direction 14. Alternatively, the at least one contact element 16 may be pinshaped, sleeve-shaped, fork-shaped or have any other shape common for electrical contact elements. The at least one contact element 16 may be soldered, crimped, welded and/or connected by any other conventional termination technique to a conductor (not shown) of an electrical cable (not shown) within the connector housing 6.

In the shown exemplary embodiment, the electrical connector 1 comprises two contact elements 16. In particular, the electrical connector 1 comprises two contact elements 16 extending along the mating direction 14 and parallel to each other. The number and/or orientation of contact elements 16, however, may be adapted according to the application of the electrical connector 1.

As can be seen, the electrical connector 1 further comprises a preferably insulative cover structure 20 for restricting access to the contact elements 16. The cover structure 20 may be embodied by the connector housing 6 or be separately assembled to the connector housing 6. Alternatively, parts of the cover structure 20 may be monolithically connected to the connector housing 6. Other parts may be assembled to the connector housing 6 as separate components.

The cover structure 20 comprises a preferably static wall element 22. Said wall element 22, for example, may be monolithically connected to the connector housing 6. In the shown exemplary embodiment, the cover structure 20 comprises one wall element 22 for each contact element 16. Each wall element 22 at least partly surrounds the corresponding contact element 16 in a spaced apart manner. In particular, each wall element 22 comprises multiple wall sections 24, which extend parallel to and spaced apart from the corresponding contact element 16. The wall sections 24 of each wall element 22 may be arranged in a closed shape around the corresponding contact element 16. In particular, the wall sections 24 may form a substantially cuboid, box-shaped enclosure 26 around the corresponding contact element 16. Between each wall element 22 and the corresponding contact element 16, a reception zone 28 is defined (see Fig. 3).

The cover structure 20 further comprises a preferably retractable cover element 30. The cover element 30 may be a single-piece component, preferably molded from resin. Alternatively, the cover element 30 may be manufactured by additive manufacturing and/or made from other electrically insulative materials. For each contact element 16, the cover structure 20 preferably comprises one cover element 30.

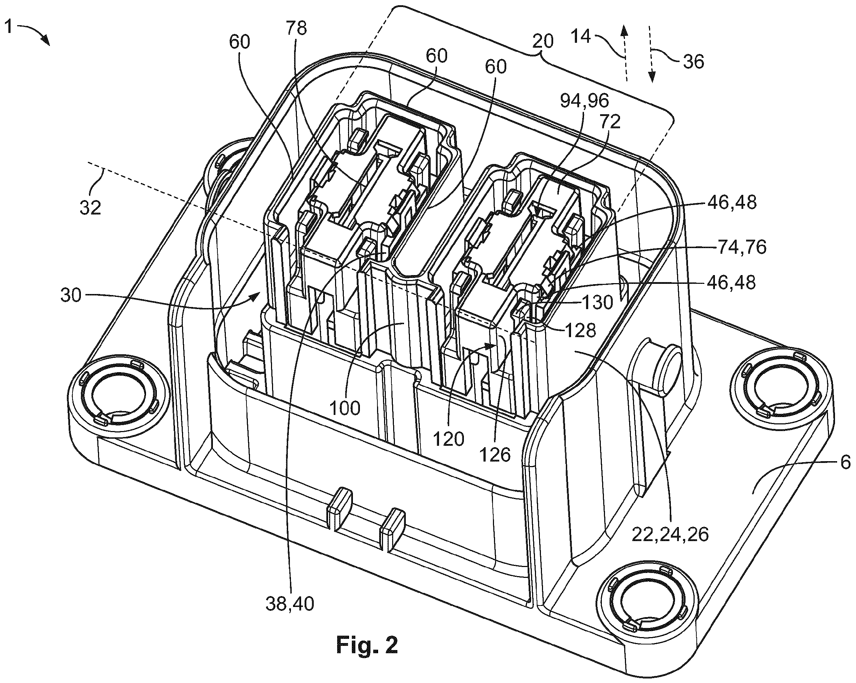

Each cover element 30 is movable, preferably slidably movable, within the reception zone 28 between the corresponding wall element 22 and contact element 16. There, each cover element 30 can be moved into a secured position 32 as shown in Fig. 2. Further, each cover element 30 can be moved into a retracted position 34 as shown in Fig. 3. In particular, each cover element 30 is movable from the secured position 32 to the retracted position 34 along a retraction direction 36, the retraction direction 36 preferably being parallel to the mating direction 14. Preferably, each cover element 30 is reciprocally movable between the secured position 32 and the retracted position 34.

The respective contact element 16 is enclosed by the corresponding cover element 30 in the secured position 32. In particular, the respective contact element 16 is covered by the corresponding contact element 16 in the retraction direction 36 and optionally in a direction perpendicular to the retraction direction 36. When the corresponding cover element 30 is moved into the retracted position 34, at least part of the contact element 16 is neither enclosed nor covered by the corresponding cover element 30.

For securing the cover element 30 in the secured position 32, the corresponding wall element 22 comprises at least one deflectable latch member 38. In particular, the at least one deflectable latch member 38 selectively hinders the cover element 30 from moving into the retracted position 34, as will be described in further detail below.

The at least one deflectable latch member 38 may be a cantilever flap 40 which has a supported end 42 monolithically connected to one of the wall sections 24 and a free end 44 extending against the retraction direction 36, as can be seen in Fig. 5. Alternatively, the supported end 42 may also be connected via a hinge (not shown) to the corresponding wall section 24.

It is to be understood that the term "deflectable" refers to a property of the at least one latch member 38 according to which the at least one latch member 38 is more elastic, more flexible, more resilient and/or more pliable than the rest of the wall element 22. In other words, a deflection of the at least one latch member 38 requires less force than a comparable deflection of any other part of the wall element 22. Optionally, the at least one latch member 38 may also exhibit a higher elasticity, flexibility, resiliency and/or pliability than any part of the cover element 30.

Optionally, the wall element 22 may comprise at least two latch members 38, which are arranged opposite to each other with respect to the corresponding contact element 16. In the shown exemplary embodiment of Figs. 1 to 3, each wall element 22 has a pair of such latch members 38. Each latch member 38 comprises at least one blocking surface 46, which faces against the retraction direction 36 and serves as an abutting surface 48 for the corresponding cover element 30. The at least one blocking surface 46 is preferably formed on an edge 50 of the free end 44 of the corresponding latch member 38 embodied by the cantilever flap 40.

Each latch member 38 may further comprise at least one bevel surface 52, which extends obliquely with respect to the retraction direction 36. The at least one bevel surface 52 may also be formed preferably on the edge 50 of the free end 44 of the corresponding latch member 38 embodied by the cantilever flap 40. Each bevel surface 52 functions as a lead-in chamfer 54 for the mating connector 2 (see Fig. 6).

As will be described with reference to Fig. 4 in further detail below, the mating connector 2 may comprise at least one deflection element 56 with an inverse surface 58, which is positioned and oriented in such a way to engage with the at least one bevel surface 52, when the electrical connector 1 and the mating connector 2 are mated. In particular, said engagement causes the corresponding latch member 38, which the at least one bevel surface 52 is a part of, to be deflected.

As can be seen in Fig. 3, outer edges 60 of each wall element 22 may define an access opening 62 leading into the reception zone 28. In particular, when the cover element 30 is in the retracted position 34, a mating contact 64 of the mating connector 2 can be inserted into the corresponding reception zone 28 through the respective access opening 62. In other words, the access opening 62 is open in the mating direction 14, when the corresponding cover element 30 is in the retracted position 34. Especially, the respective reception zone 28, and consequently the corresponding access opening 62 is vacated by the corresponding cover element 30 in the retracted position 34. Each cover element 30 in the retracted position 34 is moved into a withdrawal zone 66, which is aligned with the reception zone 28 in the retraction direction 36 (see Fig. 6). The withdrawal zone 66 lies opposite of the access opening 62 with respect to the corresponding reception zone 28. Further, the withdrawal zone 66 may lie within the connector housing 6.

As can be seen in the sectional view of Fig. 6, each reception zone 28 may have a clear width 68 larger than a clear width 70 of the corresponding withdrawal zone 66, the clear widths 68, 70 being measured particularly to the retraction direction 36.

On the other hand, the respective cover element 30 in the secured position 32 chiefly occupies the reception zone 28. In particular, the respective access opening 62 is closed by the corresponding cover element 30 in the secured position 32. For this, each cover element 30 may comprise a plate section 72, which blocks the corresponding access opening 62, when the cover element 30 is in the secured position 32.

In the secured position 32 of each cover element 30, the corresponding contact element 16 is positioned beyond the plate section 72 in the retraction direction 36. Thereby, a certain travel distance of the respective cover element 30 is necessary, until the respective contact element 16 is made accessible.

The cover structure 20 having each cover element 30 in the secured position 32 provides a finger protection for all contact elements 16 according to UL-Standard 60950 and DIN-EN-Standard 60592. The cover structure 20 having at least one cover element 30 in the retracted position 34 still provides at least a finger protection for all contact elements 16 according to DIN-EN-Standard 60592. This will be described in further detail below.

As can be seen in the sectional view of Fig. 5, each cover element 30 may comprise at least one blocking feature 74 for engaging with the at least one latch member 38 of the corresponding wall element 22. Preferably, each cover element 30 comprises for each latch member 38 at least one blocking feature 74. Each blocking feature 74 may be a nib-shaped protrusion 76 extending away from the plate section 72 perpendicularly to the retraction direction 36. Further, each blocking feature 74 may be aligned in the retraction direction 36 with one blocking surface 46 of the corresponding undeflected latch member 38. Thereby, each blocking feature 74 may abut in the retraction direction 36 against the corresponding undeflected latch member 38. This leads to the cover element 30 being maintained in its secured position 32.

If the at least one latch member 38 is deflected e.g., away from the corresponding cover element 30, the respective blocking surfaces 46 and blocking features 74 are brought out of alignment and thus do not abut against each other. This way, the corresponding cover element 30 is released and can be moved into the retracted position 34.

According to an alternative embodiment not shown in the figures, the at least one blocking feature may be a notch (not shown) extending through the plate section 72 perpendicularly to the retraction direction 36. Consequently, the at least one blocking surface 46 may be formed e.g., on a stopping protrusion (not shown) extending from the free end 44 of the corresponding latch member 38 and into the at least one blocking feature embodied by the notch. The remaining functionality may be analogous as described above.

As can be seen in Fig. 3, each contact element 16 may comprise at least one contact surface 92, which extends along the retraction direction 36. Further, the at least one contact surface 92 may border with the corresponding reception zone 28. In addition, the at least one contact surface 92 may be covered in a spaced apart manner by one wall section 24 of the corresponding wall element 22 in a direction perpendicular to the retraction direction 36. The at least one contact surface 92 may also be covered in the retraction direction 36 by the corresponding cover element 30 in the secured position 32. This prevents anything other than the mating contact 64 from accessing the corresponding contact element 16, as will be described in further detail below.

The tab-shaped contact elements 16 shown in the exemplary embodiment of Fig. 3 comprise two contact surfaces 92 on opposite sides of the contact element 16 facing outwards with respect to the contact element 16. In particular, each contact surface 92 faces the corresponding reception zone 28 and wall element 22, while being spaced apart from the corresponding wall element 22 by the reception zone 28. Thus, each contact surface 92 is accessible to the mating contact 64 (see Fig. 5) of the mating connector 2, which is inserted into the reception zone 28.

Alternatively, the contact elements 16 may comprise inwardly facing contact surfaces (not shown).

The cover structure 20 may further comprise a cap element 78, preferably for each contact element 16. The cap element 78 covers at least a tip section 80 of the corresponding contact element 16. In particular, the cap element 78 comprises a top section 82 adjacent to the tip section 80 of the corresponding contact element 16. Said top section 82 covers the tip section 80 in the retraction direction 36. In other words, the top section 82 protects the tip section 80 against access from the retraction direction 36. For this, the top section 82 may be mechanically attached, glued, overmolded or otherwise fixed to the tip section 80.

The cap element 78 may further comprise at least one side section 84 extending along at least one side edge 86 of the corresponding contact element 16. As shown in Fig. 3, the cap element 78 may comprise two side sections 84 respectively extending in the retraction direction 36 along two opposite side edges 86 of the corresponding contact element 16. In particular, the top section 82 and the side sections 84 may be monolithically connected, hence allowing the cap element 78 to at least partly encircle the corresponding contact element 16.

The top section 82 of the cap element 78 may exhibit a material width 88 smaller than a material width 90 of the side sections 84 of the cap element 78, the material widths 88, 90 being measured in a direction perpendicular to the retraction direction 36. In particular, the material widths 88, 90 are measured in a direction perpendicular to the contact surfaces 92 of the corresponding contact element 16. Thus, in a cross-section perpendicular to the retraction direction 36, the cap element 78 may exhibit a double T-shaped profile.

The wall element 22 in combination with the cap element 78 forms a finger protection for the corresponding contact element 16. In particular, a finger protection according to DIN-EN-Standard 60592 is established thereby. In other words, a finger probe (not shown) having a dimension as defined in DIN-EN-Standard 60592 is hindered by the wall element 22 and/or the cap element 78 from reaching the contact surfaces 92 of the corresponding contact element 16.

In addition, the wall element 22, the cap element 78 and the cover element 30 in the secured position 32 also jointly form a finger protection for the corresponding contact element 16. In particular, a finger protection according to DIN-EN-Standard 60592 and UL-Standard 60950, respectively, is established thereby. In other words, neither the finger probe having the dimension as defined in DIN-EN-Standard 60592 nor a finger probe 104 having a dimension as defined in UL-Standard 60950 can reach the contact surfaces 92 of the corresponding contact element 16, due to being hindered therefrom by the wall element 22, the cap element 78 and/or the cover element 30 in the secured position 32. This is shown exemplarily in Fig. 1 with two finger probes 104 according to UL-Standard 60950 being prevented from entry into the reception zone 28, respectively, along the retraction direction 36 and perpendicularly to the retraction direction 36.

Each cover element 30 may comprise an orifice 94 for passing the corresponding contact element 16 and/or the corresponding cap element 78 therethrough. The orifice 94 may in particular be a slit 96 extending in the retraction direction 36. The slit 96 is preferably thin enough to prevent entry of any of the finger probes mentioned above. Furthermore, the orifice 94 embodied by the slit 96 may be shaped complementarily to the double T-shaped profile of the cap element 78, as shown in Fig. 2. The orifice 94 may extend through the plate section 72 of each cover element 30.

At least one guiding groove 98 extending along the retraction direction 36 may be formed on the at least one latch member 38. As is shown in Fig. 3, multiple guiding grooves 98 may be formed on each latch member 38. In particular, each guiding groove 98 may extend from the free end 44 towards the supported end 42 of the corresponding latch member 38 embodied by the cantilever flap 40. Optionally, the guiding grooves 98 may extend beyond the supported end 42 in the retraction direction 36 and through the wall element 22.

As can further be observed from Fig. 3, the guiding grooves 98 may be adapted to receive the blocking features 74 of the cover element 30. Further, the guiding grooves 98 may be adapted to receive the deflection elements 56 of the mating connector 2. In particular, each blocking feature 74 and each deflection element 56 may be received in a guiding groove 98.

For increased stability, the wall elements 22 may be monolithically connected to each other by a connecting wall 100 (see Fig. 2). Alternatively, the cover structure 20 may comprise one wall element 22 for all contact elements 16. Also alternatively, the cover structure 20 may comprise one cover element 30 for all contact elements 16.

Fig. 4 shows a sectional view of the mating connector 2 according to an exemplary embodiment of the present disclosure. The mating connector 2 may comprise a mating housing 102 with a female connector face 8b configured for receiving the male connector face 8a of the electrical connector 1.

As already described above, the mating connector 2 may further comprise the mating contact 64 (see Fig. 5). Preferably, the mating connector2 comprises one mating contact 64 for each contact element 16 of the electrical connector 1. Each mating contact 64 may for example be a fork-shaped contact 106 configured for electrically contacting the corresponding tab-shaped contact 18 of the electrical connector 1. Each mating contact 64 may be soldered, crimped, welded and/or connected by any other conventional termination technique to a conductor (not shown) of an electrical cable (not shown) within the mating housing 102.

As can further be seen in Fig. 4, the mating connector 2 may comprise a mating cover 108 arranged within the female connector face 8b. The mating cover 108 may comprise for each mating contact 64 a pillar-shaped contact guard 110 extending along the mating direction 14. Each contact guard 110 may surround the corresponding mating contact 64. Further, each contact guard 110 may be formed complementarily to the reception zones 28 of the electrical connector 1. In the shown exemplary embodiment, each contact guard 110 is cuboid and box-shaped.

On a top surface 112, each contact guard 110 may have a slot 114, which is shaped complementarily to the cap element 78 of the electrical connector 1. Optionally, the shape of the slot 114 may be congruent with the shape of the orifices 94 of the cover element 30 of the electrical connector 1.

Fig. 5 shows a detail of a sectional view of the connector assembly 4 comprising the electrical connector 1 and the mating connector 2. The connector assembly 4 is shown in a state of the mating process where the electrical connector 1 and the mating connector 2 are aligned along the mating direction 14. It is apparent that when the respective contact guard 110 is inserted into the corresponding reception zone 28 through the corresponding access opening 62, the corresponding contact element 16 and cap element 78 are passed through the slot 114. In particular, the contact surfaces 92 of the corresponding contact element 16 can be brought into electrical contact with the mating contact 64 within the respective contact guard 110.

For the respective contact guard 110 to be insertable into the corresponding reception zone 28, the cover element 30 being secured against movement in the secured position 32 has to be released. To achieve this, the mating connector 2 may further comprise the at least one deflection element 56 for deflecting the at least one latch member 38 of the electrical connector 1. The at least one deflection element 56 may be a hump-shaped or prismatic bulge 118 formed on the contact guard 110. Said bulge 118 may comprise the inverse surface 58 described above.

Prior to and/or during the insertion of the respective contact guard 110 into the corresponding reception zone 28, the inverse surface 58 and the bevel surface 52 of the at least one latch member 38 slide along each other. Since these surfaces 52, 58 extend obliquely with respect to the mating direction 14, the movement of the mating connector 2 along the mating direction 14 is transformed into a movement of the latch member 38 perpendicularly to the mating direction 14. In other words, the at least one latch member 38 is wedged aside by the corresponding deflection element 56, thus deflecting the respective latch member 38 away from the corresponding cover element 30. As already described above, such a deflection leads to the respective blocking surfaces 46 and blocking features 74 being brought out of alignment and out of abutment. Hence, the corresponding cover element 30 is released. Preferably, the cover element 30 can only be released this way.

Thereafter, the respective contact guard 110 abuts with its top surface 112 against the plate section 72 of the corresponding cover element 30. Thereby, the cover element 30 is pushed and moved from the secured position 32 to the retracted position 34 during the mating process.

Preferably, the at least one latch member 38 is only deflected, when the at least one deflection element 56 enters the corresponding reception zone 28 of the electrical connector 1. In other words, the at least one latch member 38 is only deflected, when the at least one deflection element 56 is in the access opening 62. As the at least one deflection element 56 is moved away from the access opening 62 and towards the withdrawal zone 66, the at least one deflection element 56 is received within one of the guiding grooves 98 formed on the corresponding latch member 38. In particular, the at least one deflection element 56 is entirely accommodated within the guiding groove 98 and thus does not mechanically interfere with the corresponding latch member 38.

Analogously, each blocking feature 74 embodied by the nib-shaped protrusions 76 is also received and entirely accommodated within one of the guiding grooves 98, so as to not mechanically interfere with the corresponding latch member 38.

If the electrical connector 1 and the mating connector 2 are unmated, in particular when the at least one deflection element 56 exits the reception zone 28 through the access opening 62, the deflection element 56 wedges the respective latch member 38 aside as was the case during the mating process.

Further, when the electrical connector 1 and the mating connector 2 are unmated, all cover elements 30 preferably return from the retracted position 34 to the secured position 32, respectively. To achieve this, each cover element 30 may comprise at least one catch section 120 for interacting with a snap element 122 of the mating connector 2. For example, the at least one catch section 120 and snap element 122 may form a connection, such as a snap-fit connection, as can be seen in the sectional view of Fig. 6. The mating connector 2 may comprise multiple snap elements 122. Accordingly, each cover element 30 may comprise one catch section 120 for each snap element 122.

The snap elements 122 may be hook-shaped, knob-shaped or rib-shaped projections 124 formed on the mating connector 2 and pointing in the retraction direction 36. Further, the snap elements 122 may be received within the respective catch sections 120. In particular, each catch section 120 may be formed by a side wall 126 of the cover element 30 and a flexible cantilever beam 128 extending parallel to the side wall 126 along the retraction direction 36. The side wall 126 and/or the cantilever beam 128 may have a catching protrusion 130 extending towards the cantilever beam 128 and the side wall 126, respectively. Alternatively, the at least one catch section 120 may be formed by two flexible cantilever beams (not shown) extending parallel to each other. Further, alternatively, the allocations of the snap elements 122 and the catch sections 120 may be inverted between the electrical connector 1 and the mating connector 2.

Upon reception of the respective snap element 122 in the corresponding catch section 120, the snap-fit connection may be established. Said snap-fit connection allows the cover element 30 to closely follow a movement of the mating connector 2 along the retraction direction 36. In particular, the cover element 30 does not move into the retracted position 34 by its own gravity. In other words, the cover element 30 does not fall into the withdrawal zone 66 as long as the snap-fit connection with the mating connector 2 is in place. The cover element 30 only moves into the retracted position 34, when pushed by the mating connector 2, as described above.

Accordingly, the cover element 30 is pulled out of the withdrawal zone 66 and returned to the secured position 32 by the mating connector 2 via the snap-fit connection, when the mating connector 2 is moved against the retraction direction 36 e.g, during the un-mating process. Thereby, an occurrence of a gap between the mating connector 2 and the cover element 30 after the release of the cover element 30 from the secured position 32 is prevented at all times.

To ensure that the respective snap element 122 is not let go by the corresponding catch section 120, unless the cover element 30 is in the secured position 32, each catch section 120 may exhibit a higher rigidity when the cover element 30 is in the retracted position 34 than when the cover element 30 is in the secured position 32. This can be achieved as follows:
In the retracted position 34 of the cover element 30, the cantilever beam 128 is positioned within the withdrawal zone 66. In particular, the clear width 70 of the withdrawal zone 66 described above is such that the cantilever beam 128 rests against the wall element 22. Thus, the cantilever beam 128 is limited in its movement or entirely loses its flexibility. Thereby, the snap element 122 is firmly held within the catch section 120.

In this case, the terms "firmly held" refer to a state where a force required for pulling the snap element 122 out of the corresponding catch section 120 is larger than the weight force of the cover element 30 and/or the friction force acting between the cover element 30 and the rest of the electrical connector 1.

In the secured position 32 of the cover element 30, the cantilever beam 128 is positioned within the reception zone 28. Due to the larger clear width 68 of the reception zone 28 compared to the withdrawal zone 66, as described above, the cantilever beam 128 is spaced apart from the wall element 22 and thus maintains its flexibility. Consequently, the snap element 122 can easily enter or leave the catch section 120.

It is to be understood that the terms "easily enter or leave" refer to a state where the force required for inserting the snap element 122 into the corresponding catch section 120 as well as pulling the snap element 122 out of the corresponding catch section 120 is smaller than a resisting force acting between the cover element 30 and the rest of the electrical connector 1. Said resisting force may for example derive from the blocking features 74 and/or from hook-shaped anchoring latches 132 (see Fig. 1), which are formed on the cover element 30 and engage in a latching connection with the wall element 22.

Additionally or alternatively, a resilient position restoration element (not shown), such as a coil spring can be used to bias the cover element 30 towards the secured position 32 and out of the retracted position 34.

Optionally, one of the electrical connector 1 and mating connector 2 may comprise a lever 134 for facilitating the mating process (see Fig. 4). Further, one of the electrical connector 1 and mating connector 2 may optionally comprise a sealing element 136, which is interposed between the electrical connector 1 and mating connector 2 in the mated condition (see Figs. 5 and 6).

### REFERENCE NUMERALS

- 1: electrical connector
- 2: mating connector
- 4: connector assembly
- 6: connector housing
- 8, 8a, 8b: connector face
- 14: mating direction
- 16: contact element
- 18: tab-shaped contact
- 20: cover structure
- 22: wall element
- 24: wall section
- 26: enclosure
- 28: reception zone
- 30: cover element
- 32: secured position
- 34: retracted position
- 36: retraction direction
- 38: latch member
- 40: cantilever flap
- 42: supported end
- 44: free end
- 46: blocking surface
- 48: abutting surface
- 50: edge
- 52: bevel surface
- 54: lead-in chamfer
- 56: deflection element
- 58: inverse surface
- 60: outer edge
- 62: access opening
- 64: mating contact
- 66: withdrawal zone
- 68: clear width
- 70: clear width
- 72: plate section
- 74: blocking feature
- 76: protrusion
- 78: cap element
- 80: tip section
- 82: top section
- 84: side section
- 86: side edge
- 88: material width
- 90: material width
- 92: contact surface
- 94: orifice
- 96: slit
- 98: guiding groove
- 100: connecting wall
- 102: mating housing
- 104: finger probe
- 106: fork-shaped contact
- 108: mating cover
- 110: contact guard
- 112: top surface
- 114: slot
- 118: bulge
- 120: catch section
- 122: snap element
- 124: projection
- 126: side wall
- 128: cantilever beam
- 130: catching protrusion
- 132: anchoring latche
- 134: lever
- 136: sealing element

## Claims

1. Electrical connector (1) comprising at least one contact element (16) and a cover structure (20) for restricting access to the at least one contact element (16), wherein the cover structure (20) comprises:
- a wall element (22) at least partially surrounding the at least one contact element (16) in a spaced apart manner, thereby defining a reception zone (28) between the wall element (22) and the at least one contact element (16), and
- a cover element (30), which is movable within the reception zone (28) along a retraction direction (36) from a secured position (32) to a retracted position (34),
wherein the at least one contact element (16) is enclosed by the cover element (30) in the secured position (32), and wherein the wall element (22) comprises at least one deflectable latch member (38) for securing the cover element (30) in the secured position (32).

2. Electrical connector (1) according to claim 1, wherein the at least one contact element (16) comprises at least one contact surface (92), which extends along the retraction direction (36) and borders with the reception zone (28).

3. Electrical connector (1) according to claim 1 or 2, wherein the cover structure (20) comprises a cap element (78), which covers at least a tip section (AP) of the at least one contact element (16).

4. Electrical connector (1) according to any one of claims 1 to 3, wherein the cover element (30) comprises an orifice (94) for passing the at least one contact element (16) therethrough.

5. Electrical connector (1) according to any one of claims 1 to 4, wherein at least one guiding groove (98) extending in the retraction direction (36) is formed on the at least one latch member (38).

6. Electrical connector (1) according to any one of claims 1 to 5, wherein the wall element (22) comprises at least two latch members (38), which are arranged opposite to each other with respect to the at least one contact element (16).

7. Electrical connector (1) according to any one of claims 1 to 6, wherein outer edges (60) of the wall element (22) define an access opening (62) leading into the reception zone (28).

8. Electrical connector (1) according to claim 7, wherein the cover element (30) is movable between the secured position (32) and the retracted position (34), wherein the access opening (62) is closed by the cover element (30) in the secured position (32), and wherein the reception zone (28) is accessible through the access opening (62), when the cover element (30) is in the retracted position (34).

9. Electrical connector (1) according to any one of claims 1 to 8, wherein the cover element (30) comprises at least one blocking feature (74) for engaging with the at least one latch member (38).

10. Electrical connector (1) according to any one of claims 1 to 9, wherein the cover element (30) comprises at least one catch section (120) for interacting with a snap element (122) of a mating connector (2).

11. Electrical connector (1) according to any one of claims 1 to 10, wherein the cover element (30) is a single-piece component.

12. Electrical connector (1) according to any one of claims 1 to 11, wherein the electrical connector (1) comprises a connector housing (6), to which the wall element (22) of the cover structure (20) is monolithically connected.

13. Mating connector (2) for establishing an electrical connection with an electrical connector (1) according to any one of claims 1 to 12, wherein the mating connector (2) comprises at least one mating contact (64) configured for electrically contacting the at least one contact element (16) of the electrical connector (1), and wherein the mating connector (2) further comprises at least one deflection element (56) for deflecting the at least one latch member (38) of the electrical connector (1).

14. Mating connector (2) according to claim 13, further comprising at least one snap element (122) pointing in the retraction direction (36) for forming a connection with the electrical connector (1).

15. Connector assembly (4) comprising an electrical connector (1) according to any one of claims 1 to 12 and a mating connector (2) according to claim 13 or 14, wherein the at least one latch member (38) of the electrical connector (1) is deflected by the at least one deflection element (56) of the mating connector (2) when the at least one deflection element (56) enters the reception zone (28) of the electrical connector (1).
